# EUROPEAN PATENT SPECIFICATION

(11) **EP 1 272 586 B1**
(45) Date of publication and mention of the grant of the patent: **02.06.2004**
(21) Application number: 01918397.9
(22) Date of filing: 07.03.2001
(51) Int. Cl.: C09J 163/00, C08G 59/24, H01B 1/22

(54) **ANISOTROPICALLY CONDUCTIVE ADHESIVE COMPOSITION AND ANISOTROPICALLY CONDUCTIVE ADHESIVE FILM FORMED FROM IT**
ANISOTROPISCH LEITFÄHIGE KLEBSTOFFZUSAMMENSETZUNG UND DARAUS HERGESTELLTE ANISOTROPISCH LEITFÄHIGE KLEBSTOFFFOLIE
COMPOSITION ADHESIVE A CONDUCTIVITE ANISOTROPE ET COUCHE MINCE ADHESIVE A CONDUCTIVITE ANISOTROPE PREPAREE DE CELLE-CI

(30) Priority: 24.03.2000 JP 2000088552
(43) Date of publication of application: 08.01.2003
(73) Proprietor: 3M Innovative Properties Company, St. Paul, MN 55133-3427 (US)
(72) Inventor: Yamaguchi, Hiroaki, Yamato, Kanagawa 242-003 (JP); Hiroshige, Yuji, Tama, Tokyo 206-0032 (JP); Hata, Michiru, Sagamihara, Kanagawa 229-0032 (JP); Kitamura, Tetsu, Kawasaki, Kanagawa 214-0033 (JP)
(74) Representative: VOSSIUS & PARTNER
(86) International application number: PCT/US2001/007234
(87) International publication number: WO 2001/072919

(56) References cited:
- DE-A- 19 534 594
- DE-A- 19 648 283
- US-A- 5 667 893
- US-A- 5 863 970
- PATENT ABSTRACTS OF JAPAN vol. 1999, no. 12, 29 October 1999 (1999-10-29) & JP 11 181391 A (NIPPON KAYAKU CO LTD), 6 July 1999 (1999-07-06)

## Description

### Field of the Invention

The present invention relates to an anisotropically conductive adhesive composition and to an anisotropically conductive adhesive film formed from it.

### Background of the Invention

Anisotropically conductive adhesives that contain epoxy resin-based adhesives are known for adhesives used to bond circuit substrates, such as FPC (flexible printed circuits), or TAB (tape automated bondings) and PCB (printed circuit boards) or glass circuit boards, together while allowing electrical connection between the electrodes. The principal property demanded of such adhesives is the ability to harden within a short time at relatively low temperature so that the circuit substrate undergoes no thermal damage. An additional property is to provide a reliable electrical connection.

For example, Japanese Unexamined Patent Publication (Kokai) No. 7-90237, discloses a circuit connection material comprising conductive particles dispersed in an adhesive component, comprising an aromatic sulfonium salt added in a prescribed amount to a cationic polymerizable substance such as an epoxy resin. Also, Japanese Unexamined Patent Publication (Kokai) No. 10-273635 discloses a circuit bonding member comprising conductive particles and an adhesive composition the essential components of which are epoxidized polybutadiene, a naphthalene-based epoxy resin, an aromatic sulfonium salt and a phenoxy resin. The conductive adhesives disclosed in these publications are both described as being capable of thermocompression bonding within 20 seconds at 130°C and within 20 seconds as 140°C. However, since the highly reactive curing agent and epoxy resin are stored in admixture, there is a risk of impaired shelf life at room temperature. Another problem is that the high temperature (about 80°C) applied in the drying step during production of the adhesive film accelerates cationic polymerization. In order to avoid this, it is necessary to carry out the drying step for a longer period at low temperature, thus lowering production efficiency.

Other examples of anisotropically conductive adhesives are disclosed in Japanese Unexamined Patent Publication (Kokai) No. 11-35903 and Japanese Unexamined Patent Publication (Kokai) No. 10-269853, which employ an organic peroxide and a vinyl ester or the like, an acrylate, methacrylate or the like. According to the examples in Japanese Unexamined Patent Publication (Kokai) No. 11-35903, the disclosed adhesive can be thermocompression bonded within 15 seconds at 130°C. According to the examples in Japanese Unexamined Patent Publication (Kokai) No. 10-269853, its adhesive can be thermocompression bonded within 30 seconds at 160°C. These technologies, however, not only present the aforementioned problem of lower production efficiency due to the drying step, but also they employ a peroxide as a raw material, raising the concern of explosion occurring by contact with metals. Therefore, since the facilities for production must be strictly prescribed, manufacturing costs increase.

An additional technology for accomplishing thermocompression bonding at lower temperature is disclosed in National Publication No, 8-511570. That case disclosed an anisotropically conductive adhesive composition comprising a cationic polymerizable monomer such as a glycidyl epoxy resin; a thermoplastic resin; a multicomponent thermal initiating agent comprising an organometallic complex cation, a stabilizing additive and a curing accelerator, and conductive particles. This publication states that the adhesive can harden rapidly at 120°C.

Another example is Japanese Unexamined Patent Publication (Kokai) No. 11-60899, which discloses a conductive epoxy resin composition comprising (a) a cycloaliphatic epoxy resin, (b) a diol, (c) a styrene-based thermoplastic elastomer with an epoxy group in the molecule, (d) an ultraviolet activatable cationic polymerization catalyst and (e) conductive particles at 1-50 parts by weight to 100 parts by weight of the cycloaliphatic epoxy resin. Also, Japanese Unexamined Patent Publication (Kokai) No. 11-116778 discloses a conductive epoxy resin composition comprising (a) a cycloaliphatic epoxy resin, (b) a tackifier with an aromatic ring in the molecule, (c) a styrene-based thermoplastic elastomer with an epoxy group in the molecule, (d) an ultraviolet activatable cationic polymerization catalyst and (e) conductive particles at 1-50 parts by weight to 100 parts by weight of the cycloaliphatic epoxy resin. These publications teach that their disclosed adhesives are capable of being cured within 30 seconds at temperatures of 70-120°C and 70-150°C, respectively.

In the conductive adhesives disclosed in these publications, a cationic polymerization catalyst of a Lewis acid or its complex is highly reactive in combination with the cycloaliphatic epoxy resin, and therefore curing occurs rapidly; however, the high reactivity also results in the problem of a short shelf life in the case of ordinary cationic polymerization catalysts. For this reason, an "ultraviolet activatable cationic polymerization catalyst" is used which has low activity as a catalyst unless subjected to ultraviolet irradiation, and exhibits higher activity upon ultraviolet irradiation. Such conductive adhesives, however, produce cationic active species such as Lewis acids after ultraviolet irradiation which results in high reactivity at relatively low temperatures in combination with the cycloaliphatic epoxy resin. It is believed that these conductive adhesives have a short working life after ultraviolet irradiation.

### Summary of the Invention

It is therefore an object of the present invention to overcome these problems of the prior art and to provide an anisotropically conductive adhesive composition and an anisotropically conductive adhesive film that exhibit superior properties. Specifically, the invention provides an anisotropically conductive adhesive composition and an anisotropically conductive adhesive film formed using the composition simultaneously endowed with the properties that (1) the composition has a long shelf life at room temperature (for example, the composition remains usable for at least about 30 days), (2) the composition before activation can be heated at relatively high temperature, since its curing reaction does not yet proceed at about 80°C, and the resulting adhesive film can be produced more efficiently in a short time compared to the prior art, since the drying process for the film formation can be shortened (3) the composition has a sufficiently long working life, which is defined as time length for which the composition can be left from activation by ultraviolet irradiation to thermocompression bonding, thus providing the sufficient time required for the thermocompression bonding procedure, which is preferably at least 10 minutes, more preferably at least 30 minutes and even more preferably at least 60 minutes considering the maintenance time, etc. in the semiconductor device mounting step for actual use, (4) the composition rapidly cures at a low temperature of 100 to 130°C during thermocompression bonding after ultraviolet activation, i.e. curability preferably within one minute, more preferably within 30 seconds and even more preferably within 10 seconds, and (5) the composition provides excellent connection stability after connection between substrates (for example, the resistance is not raised or remain the same, even after the high temperature/high humidity test as shown in table 1 of the working examples.).

"Anisotropically conductive adhesive composition" as used throughout the present specification refers to an adhesive composition capable of bonding two circuit substrates together, when the two circuit substrates are laminated together for electrical connection between conductors on the circuit substrates. Conductivity is exhibited in the direction normal to the substrate so as to provide electrical connection between conductors facing each other on the circuit substrates, but without exhibiting conductivity in the planar direction of the substrates so as to avoid shorting of adjacent circuits on the circuit substrates. In other words, the adhesive compositon exhibits anisotropic conductivity when bonded. Such adhesive compositions are usually used in the form of films, and an adhesive film formed from such an anisotropically conductive adhesive composition is called an "anisotropically conductive adhesive film". Anisotropic conductivity is a phenomenon wherein when an adhesive film is used to bond together two substrates by thermocompression bonding. The non-conductive adhesive components, which are those components other than the conductive particles, are fluidized and eliminated by the heat and pressure of thermocompression bonding, thereby providing electrical connection between the conductors on the substrates while no conductivity is exhibited in the planar direction of the substrates because of the presence of the non-conductive adhesive components.

According to the invention, there is provided an anisotropically conductive adhesive composition comprising an epoxy resin comprising a cycloaliphatic epoxy resin and a glycidyl group-containing epoxy resin, an ultraviolet activatable cationic polymerization catalyst and a cationic polymerization retarder, and conductive particles.

The invention further provides an anisotropically conductive adhesive film obtained by coating on to a support and drying a coating solution comprising such an anisotropically conductive adhesive composition with a further added thermoplastic elastomer or resin.

The composition has a long shelf life at room temperature (the composition remains usable for at least about 30 days). The composition also allows the drying step to be carried out at a relatively high temperature, about 80°C, during production of adhesive films, and can thus increase the production efficiency for adhesive films. The composition can also be rapidly cured at a low temperature of 100 to 130°C during thermocompression bonding after activation with ultraviolet rays, and has a sufficiently long working life after activation until thermocompression bonding, thus providing the sufficient time necessary for the thermocompression bonding procedure. It also exhibits excellent connection stability after connection of substrates.

### Detailed Description of the Invention

The anisotropically conductive adhesive composition of the invention is characterized by comprising as essential components thereof, an epoxy resin including (1) a cycloaliphatic epoxy resin and (2) a glycidyl group-containing epoxy resin, an ultraviolet activatable cationic polymerization catalyst, a cationic polymerization retarder, and conductive particles. The anisotropically conductive adhesive composition of the invention is usually used in the form of an adhesive film, in which case a thermoplastic elastomer or resin is added for formation of the film. The present invention will henceforth be explained in terms of its function, using an adhesive film for illustration.

The cycloaliphatic epoxy resin has the function of allowing rapid curing at low temperature, in combination with the ultraviolet activatable cationic polymerization catalyst. On the other hand, the glycidyl group-containing epoxy resin has the function of lengthening the working life of the adhesive film after ultraviolet activation, together with the cationic polymerization retarder. Additionally, the glycidyl group-containing epoxy resin has lower reactivity than the cycloaliphatic epoxy resin and has reactivity in a slightly higher temperature range. The ultraviolet activatable cationic polymerization catalyst is a compound that produces a Lewis acid or the like as a cationic active species by ultraviolet irradiation, and catalyzes an epoxy ring-opening reaction. The cationic polymerization retarder retards or inhibits cationic polymerization reaction by substituting a part of the cationic polymerization catalyst and by sequestering the Lewis acid or other cationic active species in the cationic polymerization, thereby extending the working life of the adhesive film.

In order to achieve satisfactory electrical connection between substrates using the anisotropically conductive adhesive film, it is necessary to adequately eliminate the non-conductive adhesive components from between the conductive particles and conductors on the circuit substrates by sufficient fluidization of those adhesive components by the heat and pressure of thermocompression bonding. The flow properties of the adhesive components during thermocompression bonding varies depending on the intrinsic viscosities of the resins in the adhesive and viscosity increase due to the gradually proceeding thermosetting reaction. A feature of the composition comprising a cycloaliphatic epoxy resin as the epoxy resin and comprising an ultraviolet activatable cationic polymerization catalyst is that it has high storability at room temperature, and remains usable for at least 30 days since it exhibits no catalytic function prior to activation by ultraviolet rays. However, once activated by ultraviolet rays, the composition undergoes thermosetting within a short time at low temperature. Because the thermosetting reaction proceeds rapidly after activation and viscosity increase occurs within a short time due to the thermosetting reaction, the thermocompression bonding must be carried out promptly. Addition of a cationic polymerization retarder can be considered for delaying the curing reaction. However, even when such a retarder is added, if the time until thermocompression bonding becomes extended by the time required for alignment of the circuit substrates, etc. after ultraviolet irradiation, the viscosity increase of the adhesive components due to the gradually proceeding thermosetting reaction will prevent sufficient removal of the adhesive components from between the conductive particles and the conductors on the circuit substrates, tending to result in a less stable electrical connection. On the other hand, when a glycidyl group-containing epoxy resin is included as an epoxy resin, the thermosetting reaction after ultraviolet irradiation occurs more gently thus extending the working life after activation, but it becomes necessary to increase the bonding temperature or lengthen the bonding time in order to achieve sufficient hardness for a satisfactory electrical connection.

Here, it has been demonstrated that the anisotropically conductive adhesive composition comprising an epoxy resin comprising both a cycloaliphatic epoxy resin and a glycidyl group-containing epoxy resin, an ultraviolet activatable cationic polymerization catalyst and a cationic polymerization retarder, as well as the anisotropically conductive adhesive film obtained therefrom, has a retarded viscosity increase after ultraviolet irradiation and a longer working life after activation because of the effect of the glycidyl group-containing epoxy resin and the cationic polymerization retarder, while the higher reactivity of the cycloaliphatic epoxy resin due to the combination of the cycloaliphatic epoxy resin with the ultraviolet activatable cationic polymerization catalyst provides adequate curing at low temperature and allows stabilized electrical connections.

Accordingly, the anisotropically conductive adhesive composition of the invention exhibits (1) a long shelf life at room temperature, so that the curing reaction does not proceed until activation by ultraviolet rays, (2) the composition before activation can be heated at relatively high temperature, since its curing reaction does not yet proceed at about 80°C, and the resulting adhesive film can be produced more efficiently in a short time compared to the prior art, since the drying process for the film formation can be shortened, (3) a longer working life, preferably at least 10 minutes, more preferably at least 30 minutes and even more preferably at least 60 minutes, at ordinary temperature even after activation by ultraviolet irradiation, thus allowing the thermocompression bonding procedure to be accomplished satisfactorily, (4) minimized deformation of materials by rapid thermocompression bonding (preferably within one minute, more preferably within 30 seconds and even more preferably within 10 seconds) at a low temperature of 100 to 130°C when electrical connections are established by thermocompression bonding of easily deformable materials, such as FPCs and TABs having polyester and polyimide polymer materials as basic materials or polycarbonate circuit boards and PCBs having glass-reinforced epoxy materials as basic materials, and (5) excellent mutual connectivity after connection between substrates.

According to one mode of the anisotropically conductive adhesive composition of the invention, it comprises an epoxy resin comprising a cycloaliphatic epoxy resin and a glycidyl group-containing epoxy resin, an ultraviolet activatable cationic polymerization catalyst and a cationic polymerization retarder, and conductive particles and the anisotropically conductive adhesive being used by thermocompression bonding after ultraviolet irradiation, and
1) it has a working life of at least 10 minutes, the working life being defined as time length for which the composition can be left from activation by ultraviolet irradiation to thermocompression bonding and
2) it can be completely thermoset within 60 seconds at a thermocompression bonding temperature of 100 to 130°C.

Each of the components will now be explained.

### Cycloaliphatic epoxy resin

As mentioned above, the cycloaliphatic epoxy resin improves the rapid curability and low temperature curability of the adhesive composition. The combination of this component with the ultraviolet activatable cationic polymerization catalyst allows rapid curing at low temperature. Because of the low viscosity, it also acts to increase intimate contact between the composition and the substrate. The cycloaliphatic epoxy resin used for the invention is an epoxy resin with an average of at least two cycloaliphatic epoxy groups per molecule. As examples of cycloaliphatic epoxy resins there may be mentioned the following that have two epoxy groups in the molecule: vinylcyclohexene dioxide, 3,4-epoxycyclohexylmethyl-3,4-epoxycyclohexanecarboxylate, bis(3,4-epoxycyclohexyl)adipate and 2-(3,4-epoxycyclohexyl-5,5-spiro-3,4-epoxy)cyclohexane-meta-dioxane. Polyfunctional cycloaliphatic epoxy resins having 3, 4 or more epoxy groups in the molecule (for example, Epolide GT: available from Daicel Chemical Industries, Ltd.) may also be used.

The cycloaliphatic epoxy resin used for the invention has epoxy equivalents in the range of usually 90 to 500, preferably 100 to 400, more preferably 120 to 300 and most preferably 210 to 235. With fewer than 90 epoxy equivalents, the toughness after thermosetting is reduced and the adhesive strength is lower, which may reduce the connection reliability. With more than 500 epoxy equivalents, the viscosity of the entire system is excessively increased, the flow properties are poor during thermocompression bonding or the reactivity is lowered, which may reduce the connection reliability.

### Glycidyl group-containing epoxy resin

As mentioned above, with an action of a cationic polymerization retarder, the glycidyl group-containing epoxy resin has the function of lengthening the working life of the composition after ultraviolet activation. It has lower reactivity than the cycloaliphatic epoxy resin while having a reactivity in a slightly higher temperature range. When using a composition comprising only the cycloaliphatic epoxy resin with no glycidyl group-containing epoxy resin, the curing reaction tends to proceed even at lower temperatures near room temperature, presenting the drawback of shorter working life after activation by ultraviolet irradiation. Thus, as explained above, when the time until thermocompression bonding is extended by the time required for alignment of the circuit substrates, etc., the viscosity increase of the composition due to the thermosetting reaction prevents adequate elimination of the adhesive components between the conductive particles and the conductor on each circuit substrate, thus tending to give an unstable electrical connection. The glycidyl group-containing epoxy resin compensates for this drawback of such cycloaliphatic epoxy resins. The glycidyl group-containing epoxy resin used is an epoxy resin with an average of at least two glycidyl groups in the molecule. As examples of glycidyl group-containing epoxy resins to be used for the invention there may be mentioned bisphenol A-type epoxy resins synthesized from bisphenol A and epichlorohydrin, low-viscosity bisphenol F-type epoxy resins, polyfunctional phenol-novolac epoxy resins, ortho-cresol epoxy resins and the like. Glycidyl ester-type epoxy resins such as glycidyl hexahydrophthalate ester may also be used. However, they are limited to epoxy resins having no cationic polymerization-inhibiting groups, such as amines or sulfur- or phosphorous-containing groups.

The glycidyl-containing epoxy resin used for the invention has epoxy equivalents in the range of usually 170 to 5500, preferably 170 to 1000, more preferably 170 to 500 and most preferably 175 to 210. With fewer than 170 epoxy equivalents, the toughness after thermosetting may be reduced and the adhesive strength lowered. With more than 5500 epoxy equivalents, the viscosity of the entire system is excessively increased, the flow properties are poor during thermocompression bonding or the reactivity is lowered, such that the connection reliability may be reduced.

### Mixing ratio for cycloaliphatic epoxy resin and glycidyl group-containing epoxy resin

The cycloaliphatic epoxy resin and glycidyl group-containing epoxy resin provide a satisfactory balance for the properties of the composition. Specifically, it is possible to provide a composition satisfactorily exhibiting both the low-temperature rapid curability of the cycloaliphatic epoxy resin and the long shelf life at room temperature of the glycidyl group-containing epoxy resin. The cycloaliphatic epoxy resin to glycidyl group-containing epoxy resin weight ratio is usually 20:80 to 98:2, preferably 40:60 to 94:6, more preferably 50:50 to 90:10 and most preferably 50:50 to 80:20. If the amount of the cycloaliphatic epoxy resin is less than 20% based on the total amount of the cycloaliphatic epoxy resin and the glycidyl group-containing epoxy resin, the curing properties at low tempetature may be reduced and the adhesive strength and connection reliability may be inadequate. If the amount of the cycloaliphatic epoxy resin is greater than 98%, the curing reaction may be promoted even at near room temperature, thus shortening the working life after ultraviolet irradiation.

### Ultraviolet activatable cationic polymerization catalyst

The ultraviolet activatable cationic polymerization catalyst is a compound that catalyzes an epoxy ring-opening reaction by producing a cationic active species such as a Lewis acid by ultraviolet irradiation. As examples of such polymerization catalysts there may be mentioned allyidiazonium salts, diallyliodonium salts, triallylsulfonium salts, triallylselenium salts, iron-arene complexes, and the like. Iron-arene complexes are particularly preferred because of their thermal stability, and specifically there may be mentioned xylene-cyclopentadienyl iron (II) hexafluoroantimonate, cumene-cyclopentadienyl iron (B) hexafluorophosphate and xylene-cyclopentadienyl iron (II)-tris(trifluoromethylsulfonyl) methanide.

The ultraviolet activatable cationic polymerization catalyst used for the invention is used at usually 0.05 to 10.0 parts by weight, preferably 0.075 to 7.0 parts by weight, more preferably 0.1 to 4.0 parts by weight and most preferably 1.0 to 2.5 parts by weight, with respect to 100 parts by weight of the epoxy resin. If the amount is smaller than 0.05 parts by weight, the curing properties at low temperature may be reduced and the adhesive strength and connection reliability may be inadequate. If the amount is greater than 10.0 parts by weight, the curing reaction may be promoted even at near room temperature, and the shelf life at room temperature may be reduced.

### Cationic polymerization retarder

The cationic polymerization retarder retards or inhibits the cationic polymerization reaction by substituting a part of the cationic polymerization catalyst and by sequestering the Lewis acid or other cationic active species in the cationic polymerization. Specifically there may be mentioned crown esters such as 15-crown-5. 1,10-phenanthroline and its derivatives, toluidines such as N,N-diethyl-meta-toluidine, phosphines such as triphenylphosphine, and triazines, etc.

The cationic polymerization retarder used for the invention is used at usually 0.01 to 10.0 equivalents, preferably 0.05 to 5.0 equivalents, more preferably 0.10 to 3.0 equivalents and most preferably 0.4 to 2.0 equivalents, with respect to the ultraviolet activatable cationic polymerization catalyst. If the cationic polymerization retarder is present at greater than 10.0 equivalents, the curing properties at low temperature may be reduced and the adhesive strength and connection reliability may be inadequate, while if it is present at less than 0.05 equivalents, the curing reaction may be promoted even at near room temperature, and the shelf life at room temperature may therefore be reduced.

### Conductive particles

The conductive particles used may be conductive particles such as carbon particles or metal particles of silver, copper, nickel, gold, tin, zinc, platinum, palladium, iron, tungsten, molybdenum, solder or the like, or particles prepared by covering the surface of these particles with a conductive coating of a metal or the like. It is also possible to use non-conductive particles of a polymer such as polyethylene, polystyrene, phenol resin, epoxy resin, acryl resin or benzoguanamine resin, or glass beads, silica, graphite or a ceramic, whose surfaces have been covered with a conductive coating of a metal or the like.

The mean particle size of the conductive particles used may vary depending on the electrode width and the spacing between the adjacent electrodes used for connection. For example, if the electrode width is 50 µm and the spacing between adjacent electrodes is 50 µm (i.e., the electrode pitch is 100 µm), a mean particle size of 3 to 20 µm is appropriate. By using an anisotropically conductive adhesive composition in which are dispersed conductive particles with a mean particle size in this range, it is possible to achieve fully satisfactory conductive characteristics while also adequately preventing short circuiting between adjacent electrodes. In most cases, since the pitch of the electrodes used for connection between the two circuit substrates will be from 50 to 1000 µm, the mean particle size of the conductive particles is preferably in the range of 2 to 40 µm. If they are smaller than 2 µm, they may be buried in pits in the electrode surface thus losing their function as conductive particles, and if they are larger than 40 µm they may tend to produce short circuiting between adjacent electrodes.

The amount of the conductive particles added may vary depending on the area of the electrodes used and the mean particle size of the conductive particles. A satisfactory connection can usually be achieved with a few (for example, about 2 to about 10) conductive particles present per electrode. For even lower electrical resistance, the conductive particles may be included in the composition at 10 to 300 per electrode. If a high pressure is to be applied for the thermocompression bonding, the number of conductive particles on each electrode may be increased to 300 to 1000, and the pressure may be evenly distributed to achieve a satisfactory connection. The amount of conductive particles with respect to the total volume of the composition minus the conductive particles is usually 0.1 to 30% by volume, preferably 0.5 to 10% by volume and more preferably 1 to 5% by volume. If the amount is less than 0.1% by volume, there may be a greater probability of the conductive particles being absent on the electrode when connected, thus increasing the risk of lower connection reliability. If the amount is greater than 30% by volume, short circuiting between adjacent electrodes may tend to occur.

### Thermoplastic elastomer or resin

The thermoplastic elastomer or resin is a component that is included in the composition when necessary, and particularly it is included when the composition is to be used as an anisotropically conductive adhesive film. The thermoplastic elastomer orresin increases the film formability of the adhesive film while also enhancing the impact resistance of the resulting adhesive film and alleviating residual internal stress produced by the curing reaction, for improved bond reliability. The type of polymer compound commonly known as a thermoplastic elastomer is composed of a hard segment which is a confined phase at below a certain temperature and a soft segment that expresses rubber elasticity. Such elastomers include styrene-based thermoplastic elastomers, styrene-based elastomers which are block copolymers including, for example, a styrene unit in the hard segment and a polybutadiene unit or polyisoprene unit in the soft segment. As typical. examples there may be mentioned styrene-butadiene-styrene block copolymer (SBS), styrene-isoprene-styrene block copolymer (SIS), as well as styrene-(ethylene-butylene)-styrene block copolymer (SEBS), wherein the diene component in the soft segment is hydrogenated, and styrene-(ethylene-propylene)-styrene block copolymer (SEPS). There may also be used styrene-based thermoplastic elastomers with reactive groups, such as elastomers of the type which are epoxy-modified by glycidyl methacrylate, or elastomers of the type in which the unsaturated bond of a conjugated diene is epoxidized. With such elastomers having reactive groups, the high polarity of the reactive groups increases the compatibility with the epoxy resin so that the range of formulation with epoxy resins is widened, while its incorporation into a crosslinked structure by crosslinking reaction with the epoxy resin can improve the bonding reliability after curing due to the heat and humidity resistance. An example of an epoxidized styrene-based elastomer is Epofriend A 1020 (Daicel Chemical Industries, Ltd.). In the present invention, a thermoplastic resin may also be used instead of a thermoplastic elastomer. Because the thermoplastic resin must be eliminated by fluidization during thermocompression bonding of the adhesive film in order to ensure a satisfactory electrical connection between the conductors on the bonded substrates, it is limited to a resin with a Tg of no higher than the thermocompression bonding temperature (for example, 100 to 130°C). Such resins include, for example, polystyrene resins.

When using a thermoplastic elastomer or resin that is used when necessary for the invention, it is added usually at 10 to 900 parts by weight, preferably 20 to 500 parts by weight, more preferably 30 to 200 parts by weight and most preferably 40 to 100 parts by weight with respect to 100 parts by weight of the epoxy resin. If added at less than 10 parts by weight the film formability of the composition may be reduced, and if added at greater than 900 parts by weight the flow properties of the composition as a whole at low temperature may be reduced to the point of poor contact when the conductive particles and the circuit substrate are bonded, and may result in increased electrical resistance or lower connection reliability, and sometimes lower bonding strength.

### Other additives

The anisotropically conductive adhesive composition of the invention may also contain an added cationic polymerization reaction accelerator in addition to the components mentioned above. Addition of a reaction accelerator can further improve the low temperature curability and rapid curing property. An example of such a reaction accelerator is di-tert-butyloxalate. The reaction accelerator is added in an amount in the range of usually 0.01 to 5 parts by weight, preferably 0.05 to 3 parts by weight and more preferably 0.1 to 2 parts by weight with respect to 100 parts by weight of the cycloaliphatic epoxy resin and glycidyl group-containing epoxy resin. For increased bonding between the circuit substrate and the adhesive composition, there may also be included a coupling agent, for example a silane coupling agent such as γ-glycidoxypropyltrimethoxysilane.

Other additives such as antioxidants (for example, hindered phenol-based antioxidants), diols (for example, bis(phenoxyethanol)fluorene), chain transfer agents, sensitizers, tackifiers, thermoplastic resins, fillers, flow modifier, plasticizers, antifoaming agents and the like may also be added so long as the effect of the invention is not impeded.

### Method for production of anisotropically conductive adhesive film

The anisotropically conductive adhesive film may be obtained by preparing a coating solution comprising the aforementioned anisotropically conductive adhesive composition in an appropriate solvent such as tetrahydrofuran (THF), using appropriate coating means such as a knife coater or the like to coat it onto a support such as a polymer film, and then drying the coated film. The drying is carried out at a low temperature at which the solvent evaporates. However, the adhesive composition of the invention is stable without undergoing curing reaction even at higher temperatures of about 80°C. Consequently, the drying may be carried out under increasing temperature so long as the curing reaction is not promoted, and this can improve working efficiency. The thickness of the formed adhesive film is 5 to 100 µm in order to avoid gaps between connections when the circuit substrates are connected together by thermocompression bonding, and to allow the necessary and sufficient packing.

### Electrical connection method for circuit substrates

A method will now be explained for electrical connection of conductors provided on the surfaces of two substrates (a first substrate and a second substrate). This method is substantially the same as the conventional method, except for the activation procedure by ultraviolet irradiation.

First, the conductive adhesive film is positioned in contact with the conductor of the first substrate, and the adhesive film is exposed to ultraviolet irradiation. This step is convenient for preliminary fixing of the substrate and the adhesive film when the surface of the adhesive film prior to curing has tackiness. When one side of the adhesive film is covered with a support that is transparent to ultraviolet rays, ultraviolet irradiation can be accomplished through the support. On the other hand, when the support absorbs ultraviolet rays the ultraviolet irradiation is performed after releasing the support from the adhesive film. The ultraviolet irradiation is usually performed using a high-pressure mercury lamp, and the irradiation dose is usually adjusted to 100 to 10,000 mJ/cm², as a dose sufficient for activation of the ultraviolet activatable cationic polymerization catalyst.

Next, the second substrate is positioned with the conductor of that substrate in contact with the activated adhesive film, and thermocompression bonding is accomplished at a temperature of 100 to 130°C, for example, 120°C. The working life from activation to thermocompression bonding is usually at least 10 minutes, preferably at least 30 minutes and more preferably at least about 60 minutes. The thermocompression bonding can be carried out with an iron, a heater block or a heated roll. The bonding pressure is appropriately selected so as to achieve adequate electrical connection after bonding. The pressure applied is usually in the range of 1 to 5 MPa. A bonding time of 10 seconds is usually sufficient, but there is usually no problem in terms of adhesive performance even with a bonding time of one minute or longer.

### Examples

The present invention will now be explained in further detail by way of examples. It is to be understood, however, that the invention is in no way restricted by these examples.

### Example 1

### (1) Preparation of anisotropically conductive adhesive composition

After mixing 4 g of the cycloaliphatic resin "Epolide GT401" (product name of Daicel Chemical Industries, Ltd.; epoxy equivalents = 291), 1 g of the glycidyl group-containing epoxy resin "Epikote 154" (product name of Yuka Shell Epoxy, Ltd.; epoxy equivalents = 178) and 5 g of the styrene-butadiene-styrene block copolymer "Epofriend A1020" (product name of Daicel Chemical Industries, Ltd.; epoxy equivalents = 510) with 12 g of tetrahydrofuran (THF), the mixture was stirred to uniformity. The conductive particles (gold-plated nickel particles, mean particle size of approximately 6 µm) were added in an amount of 3% by volume of a final solid, and stirring was continued until the conductive particles were thoroughly dispersed to obtain a dispersion. Separately, 0.072 g of the ultraviolet activatable cationic polymerization catalyst "Irgacure 261" (product name of Nippon Ciba Geigy, Ltd.; cumene-cyclopentadienyl iron hexafluorophosphate), 0.022 g of the cationic polymerization retarder "N,N-diethyl-m-toluidine", 0.2 g of the silane coupling agent "A187" (product name of Nippon Unicar Co., Ltd.; γ-glycidoxypropyltrimethoxysilane), 0.066 g of di-tert-butyloxalate (reaction promotor) and 0.6 g of methyl ethyl ketone (MEK) were combined and stirred to uniformity, and this mixture was added to and stirred with the aforementioned dispersion to obtain an anisotropically conductive adhesive composition.

### (2) Fabrication of anisotropically conductive adhesive film

The dispersion obtained in this manner was coated onto a silicon-treated polyester film using a knife coater, and dried for 5 minutes in air at 80°C to obtain an anisotropically conductive adhesive film with a thickness of 40 µm.

### (3) Fabrication of connection test strip for circuit substrate

An anisotropically conductive adhesive film with a width of 3 mm and a length of about 4 cm was applied onto a printed circuit board (PCB) having a construction with 196 gold-plated copper wires with a thickness of 35 µm, a conductor width of 200 µm and a pitch between conductors of 400 µm on a 0.6 mm thick FR4 glass epoxy substrate and then thermocompression bonding was carried out at 40°C for 3 seconds at a pressure of 1.4 MPa and the polyester film was released (preliminary bonding).

The surface of the anisotropically conductive adhesive film was air-cooled so as to avoid heating to a thermosetting-promoting temperature while being exposed for 15 seconds to ultraviolet rays with a center wavelength of 365 nm and an intensity of 400 mW/cm² (ultraviolet activation). The surface temperature of the anisotropically conductive adhesive film during the ultraviolet irradiation was a maximum of 30°C. The ultraviolet irradiation apparatus used was an L5662-01 spot light source with a mercury-xenon lamp as the light source, having mounted thereon an E6255 direct-ray uniform exposure unit and an A6562 UV transmitting filter (both products of Hamamatsu Photonics, KK.).

A flexible printed circuit (FPC) having a construction with 196 tin-plated copper wires with a thickness of 18 µm, a conductor width of 200 µm and a pitch between conductors of 400 µm was aligned on a 75-µm thick polyimide film and affixed onto the anisotropically conductive adhesive film that had been subjected to preliminary bonding. The anisotropically conductive film portion thereof was subjected to thermocompression bonding at 120°C for 10 seconds under 3.0 MPa pressure to obtain a circuit connection test strip (main bonding).

### (4) Electrical resistance test and heat/humidity resistance test

### (4-1) Bonding immediately after ultraviolet activation

The electrical resistance between the PCB and the FPC with the circuit connection test strip subjected to main bonding immediately after ultraviolet irradiation was measured using a digital multimeter, and the maximum values are shown in Table 1 (in the row: "Normal", "Immediate after bonding"). After allowing the test strip to stand for 240 hours in an atmosphere at 85°C/85% RH (relative humidity), the electrical resistance was measured in the same manner and the heat/humidity resistance of the test strip (connection reliability) was evaluated (in the row: "Normal", "85°C/85% RH" in Table 1).

### (4-2) Bonding after lapse of 60 minutes from ultraviolet activation

A test strip subjected to main bonding after standing for 60 minutes in an atmosphere at 30°C and 70% RH after ultraviolet irradiation was tested in the same manner as above. The results are shown in Table 1 in the rows: "RT60 minutes", "Immediate after bonding" and "RT60 minutes", "85°C-85% RH".

### Example 2

The test conducted in Example 1 was repeated, but with the amount of cationic polymerization retarder changed as shown in Table 1.

### Example 3

The test conducted in Example 1 was repeated, but using Epikote YL980 (product of Yuka Shell Epoxy, Ltd.; epoxy equivalents = 189) instead of Epikote 154 as the glycidyl group-containing epoxy resin.

### Comparative Examples 1-3

The same test was conducted as in Example 1, but for Comparative Example 1 the cycloaliphatic epoxy resin (GT401) was not included, for Comparative Example 2 the cationic polymerization retarder (N,N-diethyl-m-toluidine) was not included and for Comparative Example 3 the glycidyl group-containing epoxy resin (Epikote 154) was not included.

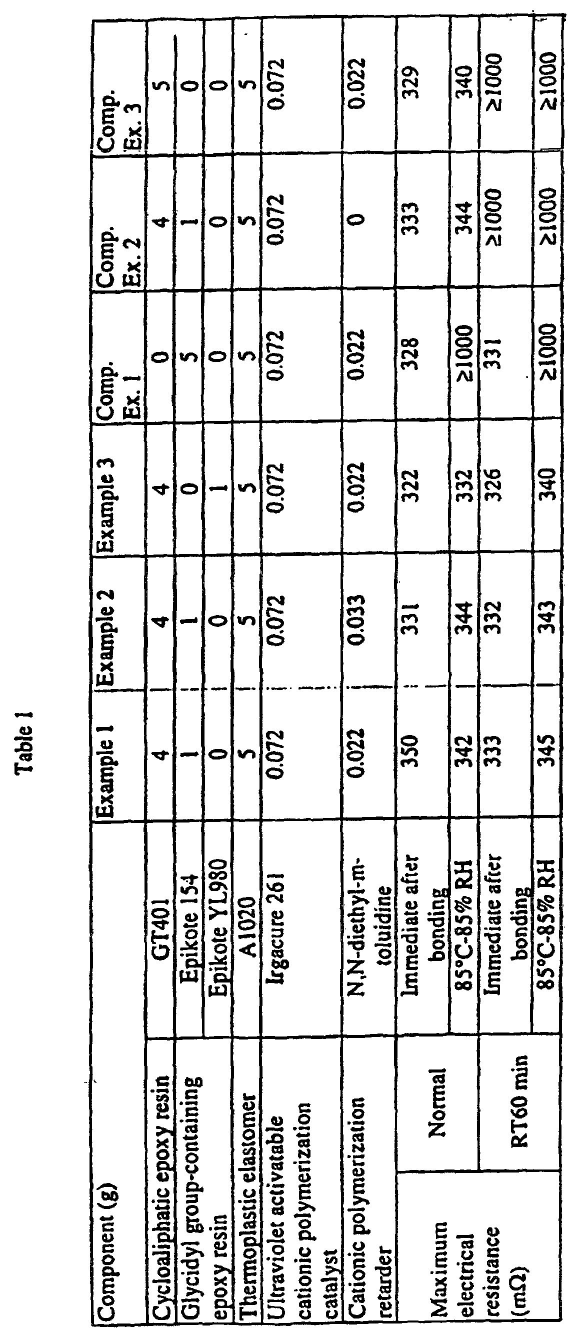

The results shown in Table 1 demonstrate that the anisotropically conductive adhesive films of the invention have working life of at least 60 minutes after ultraviolet activation, and that test strips formed using those adhesive films have excellent connection stability. On the other hand, the test strip formed using an adhesive film obtained from a composition containing no cycloaliphatic epoxy resin exhibited insufficient heat/humidity resistance, and thus had low connection stability. The adhesive films obtained from compositions containing no glycidyl group-containing epoxy resin or cationic polymerization retarder exhibited low working life.

### Effect of the Invention

The anisotropically conductive adhesive composition of the invention exhibits (1) a long shelf life at room temperature, (2) high production efficiency for adhesive films, since the curing reaction is not promoted at the high temperatures of adhesive film production, for example at a drying temperature of 80°C, (3) a sufficiently long availability after activation until thermocompression bonding, thus providing the sufficient time required for the thermocompression bonding procedure, in consideration of the maintenance time, etc. in the semiconductor device mounting step for actual use, (4) rapid curability at a low temperature of 100-130°C during thermocompression bonding after ultraviolet activation, and (5) excellent mutual connection stability after connection between substrates.

## Claims

1. An anisotrogically conductive adhesive composition comprising an epoxy resin comprising a cycloaliphatic epoxy resin and a glycidyl group-containing epoxy resin, an ultraviolet activatable cationic polymerization catalyst and a cationic polymerization retarder, and conductive particles.

2. An anisotropically conductive adhesive composition comprising an epoxy resin comprising a cycloaliphatic epoxy resin and a glycidyl group-containing epoxy resin, an ultraviolet activatable cationic polymerization catalyst and a cationic polymerization retarder, and conductive particles, the anisotropically conductive adhesive being used by thermocompression bonding after ultraviolet irradiation, wherein the composition
1) has a working life of at least 10 minutes, the working life being defined as time length for which the composition can be left from activation by ultraviolet irradiation to thermocompression bonding and
2) can be completely thermoset within 60 seconds at a thermocompression bonding temperature of 100 to 130°C.

3. An anisotropically conductive adhesive composition according to claim 1 or 2, wherein the cycloaliphatic epoxy resin to glycidyl group-containing epoxy resin weight ratio is 20:80 to 98:2.

4. An anisotropically conductive adhesive composition according to any one of claims 1 to 3, which further comprises an added thermoplastic elastomer or resin.

5. An anisotropically conductive adhesive composition according to claim 4, wherein the thermoplastic elastomer or resin is a styrene-butadiene-styrene block copolymer, and is contained in an amount of 10 to 900 parts by weight with respect to 100 parts by weight of the epoxy resin.

6. An anisotropically conductive adhesive composition according to any one of claims I to 5, wherein the ultraviolet activatable cationic polymerization catalyst is an iron-arene complex.

7. An anisotropically conductive adhesive composition according to any one of claims 1 to 6, wherein the cationic polymerization retarder is a toluidine.

8. An anisotropically conductive adhesive composition according to any one of claims 1 to 7, wherein the ultraviolet activatable cationic polymerization catalyst is cumene-cyclopentadienyl iron (II) hexafluorophosphate or xylene-cyclopentadienyl iron (II)-tris(trifluoromethylsulfonyl) methanide and the cationic polymerization retarder is N,N-diethyl-meta-toluidine.

9. An anisotropically conductive adhesive composition according to any one of claims 1 to 8, wherein the cycloaliphatic epoxy resin has 90 to 500 epoxy equivalents and the glycidyl group-containing epoxy resin has 170 to 5500 epoxy equivalents.

10. An anisotropically conductive adhesive composition according to claim 4, which comprises an epoxy resin wherein the cycloaliphatic epoxy resin to glycidyl group-containing epoxy resin weight ratio of the epoxy resin is 20:80 to 98:2, a thermoplastic elastomer or resin at 10 to 900 parts by weight with respect to 100 parts by weight of said epoxy resin, an ultraviolet activatable cationic polymerization catalyst at 0.05 to 10 parts by weight with respect to 100 parts by weight of said epoxy resin; and a cationic polymerization retarder at 0.01 to 10.0 equivalents with respect to said ultraviolet activatable cationic polymerization catalyst.

11. An anisotropically conductive adhesive composition according to any one of claims 1 to 10, which further comprises a reaction accelerator.

12. An anisotropically conductive adhesive composition according to any one of claims 1 to 11, which further comprises a coupling agent.

13. An anisotropically conductive adhesive composition according to any one of claims 1 to 12, wherein the conductive particles have a mean particle size of 2 to 40 µm.

14. An anisotropically conductive adhesive composition according to any one of claims 1 to 13, wherein the conductive particles are included at 0.1 to 30% by volume with respect to the total volume of the anisotropically conductive adhesive composition minus the conductive particles.

15. An anisotropically conductive adhesive film obtained by coating and drying a coating solution comprising an anisotropically conductive adhesive composition according to any one of claims 4 to 14 on a support.

## Patentansprüche

1. Anisotropisch leitfähige Klebstoffzusammensetzung, umfassend ein Epoxyharz, umfassend ein cycloaliphatisches Epoxyharz und ein Glycidylgruppen-enthaltendes Epoxyharz, einen ultraviolett-aktivierbaren kationischen Polymerisationskatalysator und ein kationisches Polymerisationsverzögerungsmittel, und leitfähige Teilchen.

2. Anisotropisch leitfähige Klebstoffzusammensetzung, umfassend ein Epoxyharz, umfassend ein cycloaliphatisches Epoxyharz und ein Glycidylgruppen-enthaltendes Epoxyharz, einen ultraviolett-aktivierbaren kationischen Polymerisationskatalysator und ein kationisches Polymerisationsverzögerungsmittel, und leitfähige Teilchen, wobei der anisotropisch leitfähige Klebstoff durch Thermokompressionsbinden nach ultravioletter Bestrahlung verwendet wird, wobei die Zusammensetzung
1) eine Verwendungszeit von mindestens 10 Minuten aufweist, wobei die Verwendungszeit als die Zeitspanne definiert ist, während der die Zusammensetzung von der Aktivierung durch ultraviolette Bestrahlung bis zum Thermokompressionsbinden stehen gelassen werden kann und
2) vollständig innerhalb 60 Sekunden bei einer Temperatur für das Thermokompressionsbinden von 100 bis 130 °C wärmegehärtet werden kann.

3. Anisotropisch leitfähige Klebstoffzusammensetzung nach Anspruch 1 oder 2, wobei das Gewichtsverhältnis von cycloaliphatischem Epoxyharz zu Glycidylgruppen-enthaltendem Epoxyharz 20:80 bis 98:2 beträgt.

4. Anisotropisch leitfähige Klebstoffzusammensetzung nach einem der Ansprüche 1 bis 3, die ferner ein zugesetztes thermoplastisches Elastomer oder Harz umfasst.

5. Anisotropisch leitfähige Klebstoffzusammensetzung nach Anspruch 4, wobei das thermoplastische Elastomer oder Harz ein Styrol-Butadien-Styrol Blockcopolymer ist und in einer Menge von 10 bis 900 Gewichtsteile bezogen auf 100 Gewichtsteile des Epoxyharzes enthalten ist.

6. Anisotropisch leitfähige Klebstoffzusammensetzung nach einem der Ansprüche 1 bis 5, wobei der ultraviolett-aktvierbare kationische Polymerisationskatalysator ein Eisen-Aren-Komplex ist.

7. Anisotropisch leitfähige Klebstoffzusammensetzung nach einem der Ansprüche 1 bis 6, wobei das kationische Polymerisationsverzögerungsmittel ein Toluidin ist.

8. Anisotropisch leitfähige Klebstoffzusammensetzung nach einem der Ansprüche 1 bis 7, wobei der ultraviolett-aktivierbare kationische Polymerisationskatalysator Cumolcyclopentadienyleisen(II)hexafluorphosphat oder Xylol-cyclopentadienyleisen(II)-tris(trifluormethylsulfonyl)methanid ist und das kationische Polymerisationsverzögerungsmittel N,N-Diethyl-meta-toluidin ist.

9. Anisotropisch leitfähige Klebstoffzusammensetzung nach einem der Ansprüche 1 bis 8, wobei das cycloaliphatische Epoxyharz 90 bis 500 Epoxyäquivalente aufweist und das Glycidylgruppen-enthaltende Epoxyharz 170 bis 5500 Epoxyäquivalente aufweist.

10. Anisotropisch leitfähige Klebstoffzusammensetzung nach Anspruch 4, umfassend ein Epoxyharz, wobei das Gewichtsverhältnis von cycloaliphatischem Epoxyharz zu Glycidylgruppen-enthaltendem Epoxyharz 20:80 bis 98:2 beträgt, 10 bis 900 Gewichtsteile eines thermoplastischen Elastomers oder Harzes bezogen auf 100 Gewichtsteile des Epoxyharzes, 0,05 bis 10 Gewichtsteile eines ultraviolett-aktivierbaren kationischen Polymerisationskatalysators bezogen auf 100 Gewichtsteile des Epoxyharzes und 0,01 bis 10,0 Äquivalente eines kationischen Polymerisationsverzögerungsmittels bezogen auf den ultraviolett-aktivierbaren kationischen Polymerisationskatalysator.

11. Anisotropisch leitfähige Klebstoffzusammensetzung nach einem der Ansprüche 1 bis 10, die ferner ein Reaktionsbeschleunigungsmittel umfasst.

12. Anisotropisch leitfähige Klebstoffzusammensetzung nach einem der Ansprüche 1 bis 11, die ferner ein Kupplungsmittel umfasst.

13. Anisotropisch leitfähige Klebstoffzusammensetzung nach einem der Ansprüche 1 bis 12, wobei die leitfähigen Teilchen eine mittlere Teilchengröße von 2 bis 40 µm aufweisen.

14. Anisotropisch leitfähige Klebstoffzusammensetzung nach einem der Ansprüche 1 bis 13, wobei die leitfähigen Teilchen in einer Menge von 0,1 bis 30 Volumen-% bezogen auf das Gesamtvolumen der anisotropisch leitfähigen Klebstoffzusammensetzung abzüglich der leitfähigen Teilchen enthalten sind.

15. Anisotropisch leitfähiger Klebstofffilm, der durch Beschichten und Trocknen einer Beschichtungslösung, umfassend eine anisotropisch leitfähige Klebstoffzusammensetzung nach einem der Ansprüche 4 bis 14 auf einem Träger, erhalten wird.

## Revendications

1. Composition adhésive à conductivité anisotrope comportant une résine époxy comportant une résine époxy cycloaliphatique et une résiné époxy contenant un groupe gycidyle, un catalyseur de polymérisation cationique pouvant être activé par les ultraviolets et un retardateur de polymérisation cationique, et particules conductives.

2. Composition adhésive à conductivité anisotrope comportant une résine époxy comportant une résine époxy cycloaliphatique et une résine époxy contenant un groupe gycidyle, un catalyseur de polymérisation cationique pouvant être activé par les ultraviolets et un retardateur de polymérisation cationique, et particules conductives, la composition adhésive à conductivité anisotrope étant utilisée par collage par thermocompression après irradiation ultraviolette, dans laquelle la composition
1) a une vie active d'au moins 10 minutes, la vie active étant définie comme la durée pendant laquelle la composition peut être laissée à elle-même entre l'activation par irradiation ultraviolette et le collage par thermocompression et
2) peut être complètement thermofixée dans les 60 secondes à une température de collage par thermocompression de 100 à 130°C.

3. Composition adhésive à conductivité anisotrope selon la revendication 1 ou 2, dans laquelle le rapport en poids de la résine époxy cycloaliphatique à la résine époxy contenant le groupe glycidyle va de 20/80 à 98/2.

4. Composition adhésive à conductivité anisotrope selon l'une quelconque des revendications 1 à 3, qui comporte en outre un élastomère ou une résine thermoplastique ajoutés.

5. Composition adhésive à conductivité anisotrope selon la revendication 4, dans laquelle l'élastomère ou la résine thermoplastique est un copolymère à séquences styrène-butadiène-styrène, et est contenu à hauteur de 10 à 900 parties en poids par rapport à 100 parties en poids de la résine époxy.

6. Composition adhésive à conductivité anisotrope selon l'une quelconque des revendications 1 à 5, dans laquelle le catalyseur de polymérisation cationique pouvant être activé par les ultraviolets est un complexe fer-arène.

7. Composition adhésive à conductivité anisotrope selon l'une quelconque des revendications 1 à 6, dans laquelle le retardateur de polymérisation cationique est une toluidine.

8. Composition adhésive à conductivité anisotrope selon l'une quelconque des revendications 1 à 7, dans laquelle le catalyseur de polymérisation cationique pouvant être activé par les ultraviolets est l'hexafluorophosphate de cumène-cyclopentadiényl-fer (II) ou le tris(trifluorométhylsulfonyl)méthanide de xylène-cyclopentadiényl-fer (II) et le retardateur de polymérisation cationique est la N,N-diéthyl-méta-toluidine.

9. Composition adhésive à conductivité anisotrope selon l'une quelconque des revendications 1 à 8, dans laquelle la résine époxy cycloaliphatique comporte de 90 à 500 équivalents époxy et la résine époxy contenant le groupe glycidyle comporte de 170 à 5500 équivalents époxy.

10. Composition adhésive à conductivité anisotrope selon la revendication 4, qui comporte une résine époxy dans laquelle le rapport en poids de la résine époxy cycloaliphatique à la résine époxy contenant le groupe glycidyle va de 20/80 à 98/2, un élastomère ou une résine thermoplastique à hauteur de 10 à 900 parties en poids par rapport à 100 parties en poids de ladite résine époxy, un catalyseur de polymérisation cationique pouvant être activé par les ultraviolets à hauteur de 0,05 à 10 parties en poids par rapport à 100 parties en poids de ladite résine époxy, et un retardateur de polymérisation cationique à hauteur de 0,01 à 10,0 équivalents par rapport audit catalyseur de polymérisation cationique pouvant être activé par les ultraviolets.

11. Composition adhésive à conductivité anisotrope selon l'une quelconque des revendications 1 à 10, qui comporte en outre un accélérateur de réaction.

12. Composition adhésive à conductivité anisotrope selon l'une quelconque des revendications 1 à 11, qui comporte en outre un agent de couplage.

13. Composition adhésive à conductivité anisotrope selon l'une quelconque des revendications 1 à 12, dans laquelle les particules conductives ont une taille particulaire moyenne de 2 à 40 µm.

14. Composition adhésive à conductivité anisotrope selon l'une quelconque des revendications 1 à 13, dans laquelle les particules conductives sont incluses à hauteur de 0,1 à 30 % en volume par rapport au volume total de la composition adhésive à conductivité anisotrope moins les particules conductives.

15. Couche mince adhésive à conductivité anisotrope obtenue en faisant enrober et sécher une solution d'enrobage comportant une composition adhésive à conductivité anisotrope selon l'une quelconque des revendications 4 à 14, mise sur un support.
